# EUROPEAN PATENT APPLICATION

(11) **EP 4 550 954 A1**
(43) Date of publication of application: **07.05.2025**
(21) Application number: 24210440.4
(22) Date of filing: 01.11.2024
(51) Int. Cl.: H05K 5/02, H01R 13/58, H01R 13/74

(54) **CONNECTORS FOR IN-FLIGHT ENTERTAINMENT SYSTEMS**

(30) Priority: 03.11.2023 US 202318501644
(71) Applicant: Panasonic Avionics Corporation, Irvine, CA 92612 (US)
(72) Inventor: Setele, Mark Allen, Ladera Ranch, CA (US); Jiang, Yichao, Irvine, CA (US); Olsen, Ryan, Snohomish, WA (US); Barnes, Andrew, Mission Viejo, CA (US); Vazquez, Steven Christopher, Chino, CA (US); Diaz, David, Rancho Santa Margarita, CA (US); Yamamoto, Yoshimi, Rancho Santa Margarita, CA (US); Yokota, Kiyoshi, Hirakata (JP); Kenta, Nakanishi, Hirakata (JP); Manulis, Aleksandr, San Diego, CA (US)
(74) Representative: Hamer, Thomas Daniel

(57) **Abstract**

Various connector systems, methods, and apparatuses are disclosed that can improve connectors and/or connections within an in-flight entertainment system to be at least more resilient to vibration, shock, and/or liquids. Connector boots are disclosed herein that can be coupled to a cover plate of an electronic box of an in-flight entertainment system to improve the connection between a connector plug and a receptacle of the electronic box. A cushion component and a clip are disclosed herein that can improve the connection between a connector plug and a receptacle of a monitor. Methods of disposing components of a connector plug in foil, tape, and/or heat shrink are disclosed herein that can improve resistance to liquids. Connector boots are disclosed herein that can be coupled to an in-line disconnect box to improve connections to connector plugs.

## Description

### FIELD

This disclosure is related to connector systems, methods, and apparatuses to improve passenger entertainment systems during travel such as air travel.

### BACKGROUND

Commercial travelers have come to expect reliable access to entertainment while traveling. Commercial travelers can access such entertainment with personal electronic devices (PEDs) and media play devices provided by commercial carriers.

### SUMMARY OF CERTAIN FEATURES

Disclosed herein are connector systems, methods, and apparatuses to provide commercial travelers reliable access to entertainment through entertainment systems during travel, such as air travel. Entertainment systems (e.g., in-flight entertainment systems) can be exposed to vibration (e.g., random vibration), shock (e.g., operational shock), and/or liquids during travel that can comprise the functionality of the entertainment systems and degrade passenger experiences. Connections between different electronic components of the entertainment systems can be especially vulnerable to vibration, shock, and/or liquids. Accordingly, the connector systems, methods, and apparatuses disclosed herein can improve connectors and/or connections within an entertainment system to be at least more resilient to vibration, shock, and/or liquids. The connector systems, methods, and apparatuses described herein can at least be incorporated into entertainment systems (e.g., in-flight entertainment systems) and/or other systems on commercial passenger vehicles such as aircraft (e.g., airplanes), buses, ships, trains, vans, helicopters, and/or others. In some aspects, the connector systems, methods, and apparatuses described herein can at least be incorporated into entertainment systems and/or other systems on other passenger vehicles, such as personal passenger vehicles (e.g., cars).

In some aspects, the techniques described herein relate to a connector boot configured to be disposed on a cover plate of an electronics box of an inflight entertainment system to improve resistance to fluids, vibration, or shock, the connector boot including: a plurality of openings configured to align with openings of the cover plate providing access to connector receptacles of the electronics box; and a first projection and a second projection, the first and second projections disposed on opposing sides of the connector boot; wherein the plurality of openings are configured to receive connector plugs therethrough to interface with connector receptacles of the electronics box; and wherein the connector boot is configured to be compressed between the connector plugs and the cover plate to improve resistance to fluids, vibration, or shock.

**In** some aspects, the techniques described herein relate to a connector boot, wherein the first and second projections each include a rounded profile.

In some aspects, the techniques described herein relate to a connector boot, wherein the connector boot includes: a base wall including the plurality of openings; a pair of longitudinal side walls flaring outward and disposed on opposing longitudinal sides of the base wall; a pair of end walls disposed on opposing ends of the base wall and spanning between the pair of longitudinal side walls; and a plurality of partitions, wherein each partition of the plurality of partitions is disposed between adjacent openings of the plurality of openings of the base wall; wherein the pair of longitudinal sides walls are configured to contact the connector plugs to impede relative movement between the connector plugs and the connector receptacles.

In some aspects, the techniques described herein relate to a connector boot, further including snap-fit features configured to enable the connector boot to be snap fit to the cover plate, the snap-fit features including protrusions protruding from a rear of the first and second projections.

In some aspects, the techniques described herein relate to a connector boot, further including an adhesive component disposed on the rear of the connector boot, the adhesive component configured to adhere the connector boot to the cover plate.

In some aspects, the techniques described herein relate to a connector boot, further including adhesive disposed on a rear of the connector boot, the adhesive configured to adhere the connector boot to the cover plate.

In some aspects, the techniques described herein relate to a connector boot, wherein the connector boot is over-molded onto the cover plate.

In some aspects, the techniques described herein relate to a connector boot, wherein the longitudinal side walls include an angled portion protruding from the base wall at an angle.

In some aspects, the techniques described herein relate to a connector boot, wherein the plurality of partitions span between the pair of longitudinal side walls.

In some aspects, the techniques described herein relate to a connector boot, wherein the plurality of partitions includes pairs of opposing partitions protruding from the pair of longitudinal side walls to free ends between the pair of longitudinal side walls.

In some aspects, the techniques described herein relate to an enclosure configured to be coupled to a display housing of an inflight entertainment system and enclose a connector plug to improve resistance to fluids, vibration, or shock, the enclosure including: a base configured to be coupled to the display housing; a cover with a peripheral wall, the peripheral wall having an opening through which the connector plug can interface with a connector receptacle of the display housing; a hinge rotatably coupling the cover to the base such that the cover can be rotated open to access an interior of the enclosure and rotated closed to enclose the connector plug within the interior; and an integrated cable clip configured to clamp a cable of the connector plug with the cover rotated closed to impede relative movement between the connector plug and the connector receptacle to maintain signal integrity when exposed to vibration or shock.

In some aspects, the techniques described herein relate to an enclosure, wherein the integrated cable clip includes a channel in the peripheral wall of the cover and a groove in a flange of the base that clamp the cable of the connector plug.

In some aspects, the techniques described herein relate to an enclosure, wherein the channel is configured to contact one side of the cable and the groove is configured to contact the other side of the cable.

In some aspects, the techniques described herein relate to an enclosure, wherein the channel and groove cooperate to form an aperture through which the cable extends with the cover rotated closed.

In some aspects, the techniques described herein relate to an enclosure, wherein the enclosure includes a locking mechanism configured to releasably couple the cover to the base to enclose the interior.

In some aspects, the techniques described herein relate to an enclosure, wherein the locking mechanism includes a deflectable member and a catch, and wherein one of the base and cover includes the deflectable member and the other of the base and cover includes the catch.

In some aspects, the techniques described herein relate to an enclosure, wherein the deflectable member is configured to engage an edge of the catch to releasably couple the cover to the base in the closed configuration.

In some aspects, the techniques described herein relate to an enclosure, wherein the hinge is a living hinge.

In some aspects, the techniques described herein relate to a kit including the enclosure and a sealing component, the sealing component including an adhesive configured to adhere the sealing component to the display housing around the connector receptacle, wherein the sealing component is configured to be compressed between the connector plug and the display housing to impede an ingress of fluid. The sealing component can include foam.

In some aspects, the techniques described herein relate to a cable clip configured to be coupled to a housing of an inflight entertainment system to secure a cable of a connector plug to improve resistance to vibration or shock, the cable clip including: a base plate configured to be coupled to the housing; a deflectable member including a living hinge and a locking end, the locking end including a bend and a recess, the bend configured to bias the locking end to a V-shaped configuration; and a catch including a cavity and an edge configured to engage the recess of the locking end of the deflectable member; wherein the deflectable member is configured to be bent at the living hinge to insert the locking end into the cavity such that the recess, biased by the bend, springs to engage the edge of the catch so that the cable of the connector plug is restrained between the base plate, deflectable member, and the catch.

Neither the preceding summary nor the following detailed description purports to limit or define the scope of protection. The scope of protection is defined by the claims.

### BRIEF DESCRIPTION OF THE DRAWINGS

The abovementioned and other features of the embodiments disclosed herein are described below with reference to the drawings of the embodiments. The illustrated embodiments are intended to illustrate, but not to limit, the scope of protection. Various features of the different disclosed embodiments can be combined to form further embodiments, which are part of this disclosure.
FIG. 1 schematically illustrates an in-flight entertainment system for an airplane.
FIG. 2 illustrates a block diagram of a server of an in-flight entertainment system.
FIGS. 3A, 3B, and 3C illustrate various views of an electronic box of an entertainment system, such as an in-flight entertainment system, with a connector boot.
FIG. 4A illustrates connector plugs interfacing with connector receptacles of the electronic box by way of the connector boot.
FIG. 4B illustrates a cross-sectional view of a connector plug interfacing with a connector receptacle of the electronic box by way of the connector boot.
FIGS. 5A and 5B illustrate various views of the connector boot.
FIG. 6A illustrates an exploded view of the connector boot, an adhesive component, and a cover plate of the electronic box.
FIG. 6B illustrates a connector boot over-molded on the cover plate of the electronic box.
FIG. 6C illustrates a connector boot disposed on the cover plate of the electronic box.
FIG. 6D illustrates the connector boot of FIG. 6C disposed on the cover plate separate from the electronic box.
FIG. 7 illustrates a clip and a cushion component disposed on a monitor housing of an entertainment system, such as an in-flight entertainment system.
FIG. 8A illustrates an connector plug interfacing with an upward facing receptacle of the monitor housing with the cushion component disposed therebetween and a cable of the connector plug restrained by the clip.
FIG. 8B illustrates a cross-sectional view of the connector plug interfacing with the upward facing receptacle of the monitor housing with the cushion component disposed therebetween.
FIGS. 9A and 9B illustrate various views of the cushion component.
FIG. 10A illustrates the connector plug disposed within an open enclosure while interfacing with the receptacle.
FIG. 10B illustrates the connector plug disposed within a closed enclosure while interfacing with the receptacle.
FIGS. 11A and 11B illustrate various views of the open enclosure.
FIGS. 12A and 12B illustrate various views of the closed enclosure.
FIGS. 13A and 13B illustrate a connector plug interfacing with a downward facing receptacle of the monitor housing and the cable of the connector plug retained by a clip.
FIG. 14A illustrates a cross-sectional view of the clip in an open configuration.
FIG. 14B illustrates the clip in a closed configuration.

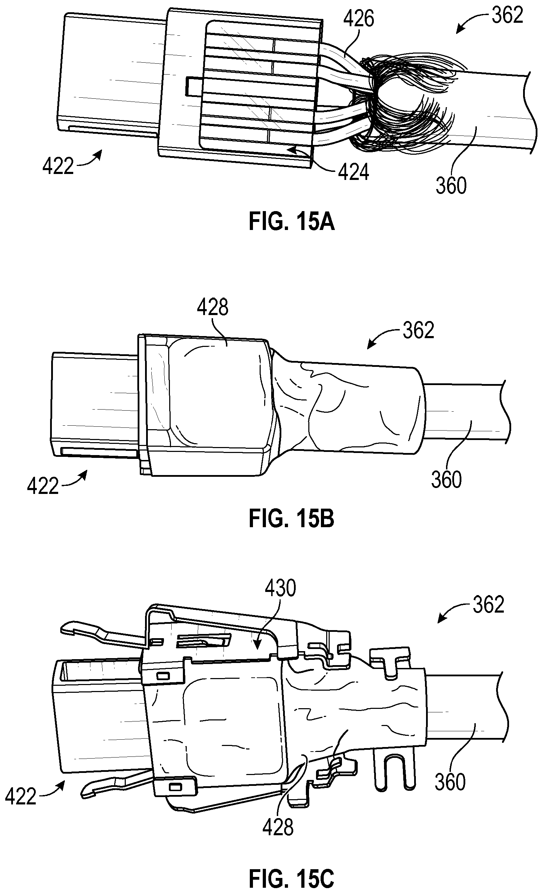

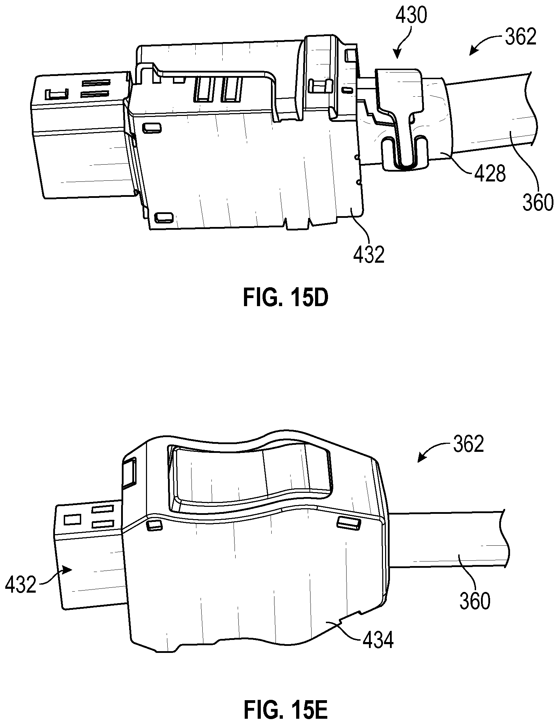

FIGS. 15A-15E illustrate a method of improving a connector plug's resistance to liquid (e.g., liquid proofing, waterproofing). FIG. 15A illustrates the connector plug with outer components removed to expose the insulation-displacement connector (IDC) unit, cable guide, and wires. FIG. 15B illustrates foil (e.g., copper foil) disposed over at least a portion of the IDC unit, wire guide, wires, and at least a portion of the cable. FIG. 15C illustrates a shield case disposed over the foil-wrapped IDC unit, wire guide, and portion of the cable. FIG. 15D illustrates a shield shell coupled to the shield case disposed over the foil-wrapped components. FIG. 15E illustrates a cover case disposed over the internal components of the connector plug.
FIGS. 16A-16C illustrate various methods of improving a connector plug's resistance to liquid (e.g., liquid proofing, waterproofing). FIG. 16A illustrates wrapping (e.g., tape) disposed over at least a portion of the cable and internal components (e.g., wires) proximate the entry of the cable into the cover case of the connector plug. FIG. 16B illustrates heat shrink disposed over the portion of the cable proximate the case cover of the connector plug. FIG. 16C illustrates heat shrink disposed over at least a portion of the cable and a portion of the case cover of the connector plug.
FIG. 17A illustrates an in-line disconnect box with connector boots.
FIG. 17B illustrates a connector plug interfacing with the in-line disconnect box by way of one connector boot.
FIG. 18 illustrates a covering coupled to the monitor housing over the connector plug interfacing with a connector receptacle of a monitor.
FIG. 19 illustrates a cover that can be disposed over the connector plug that interfaces with a connector receptacle of a monitor.
FIG. 20 illustrates a cover that can be disposed over the connector plug that interfaces with a connector receptacle of a monitor.

### DETAILED DESCRIPTION OF CERTAIN EMBODIMENTS

Although certain embodiments and examples are described below, this disclosure extends beyond the specifically disclosed embodiments and/or uses and obvious modifications and equivalents thereof. Thus, it is intended that the scope of this disclosure should not be limited by any particular embodiments described below.

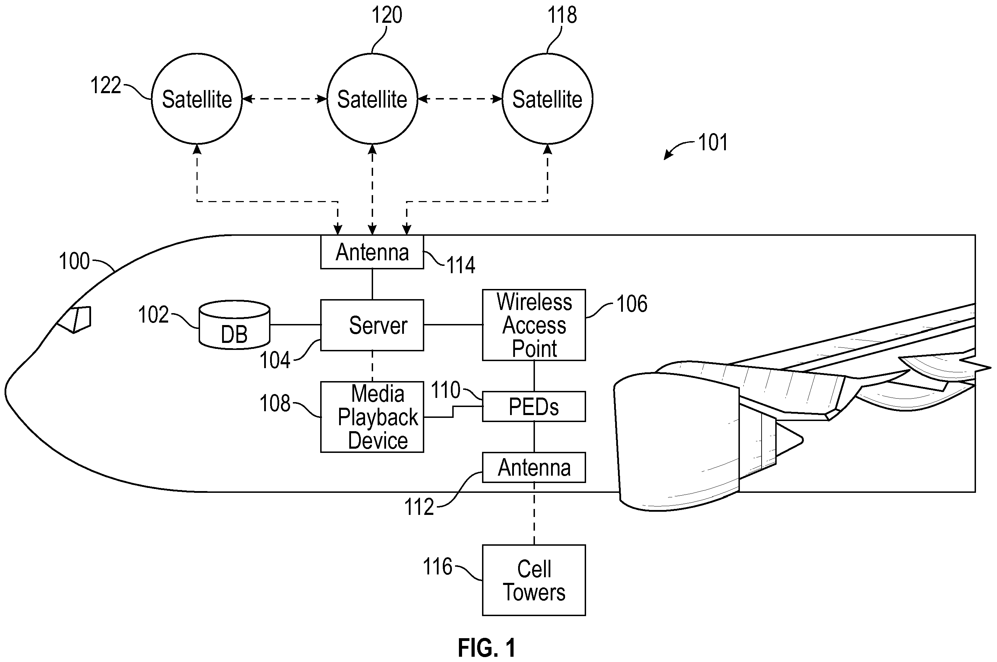

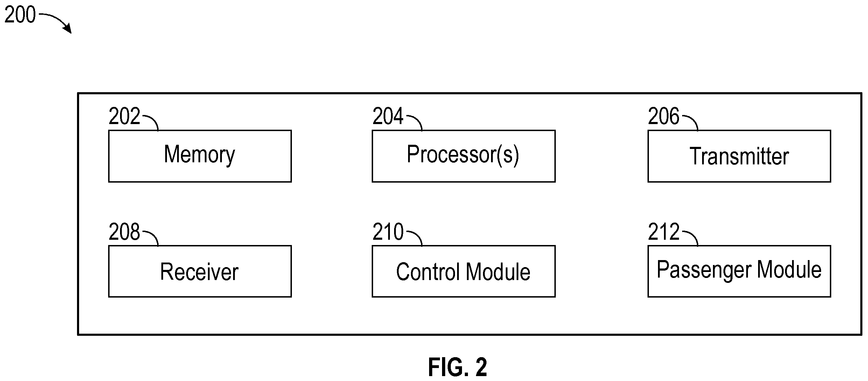

### A. In-Flight Entertainment System Overview - FIGS. 1 and 2

FIG. 1 shows an example of an in-flight entertainment (IFE) system 101 of an airplane 100. The IFE system 101 can include media playback device(s) 108, personal electronic device(s) (PED) 110, wireless access point 106, server 104, database 102, antenna 114, antenna 112, and/or other features. The media playback devices 108 can be provided at each passenger seat. The PEDs 110 (e.g., smart phones, tablet computers, laptop computers, and other portable electronic devices) can be carried onboard by passengers. The media playback devices 108 and/or PEDs 110 can include capabilities for video, audio, and/or internet communications. The server 104 can communicate with the media playback devices 108 and the PEDs 110 with wired and/or wireless connections. In some aspects, communication among the server 104, media playback devices 108, and/or PEDs 110 can be realized through the antenna 112 to and from ground-based cell towers 116 by, for example, a provision of network plugs at the seats of the airplane 100 for plugging in PEDs 110 to a wired onboard local area network. In some aspects, communications among the server 104, media playback devices 108, and PEDs 110 can be realized through the antenna 114 to and from satellites 118, 120, and/or 122 in an orbit, e.g., via a cellular network utilizing one or more onboard base station(s), Wi-Fi utilizing the wireless access point 106, and/or Bluetooth.

The components included in the IFE system 101, e.g., the server 104, media playback device 108, wireless access point 106, database 102, PEDs 110, antenna 112, and/or antenna 114, can include supporting hardware, plug connectors, cabling, wiring, monitors, wire harnesses, etc., which can collectively be referred to as electronic components. The electronic components can be configured to perform various functions that can include video/audio processing, user interface rendering, graphic/games rendering, communication, data storage, etc. for supporting the IFE system 101 disposed in the airplane 100 or other passenger vehicle (e.g., commercial passenger vehicle).

FIG. 2 shows an example of a block diagram of a server 200 of an IFE system 101. The server 200 can include one or more of each of the following: a processor 204, a memory 202, a transmitter 206, a receiver 208, a control module 210, and/or a passenger module 212. The memory 202, which can be accessed by the processor 204, can be an electronic holding place or storage for information or instructions. The instructions, upon execution by the processor 204, can configure (e.g., command) the server 200 to perform operations. The processor(s) 204 can be in communication with the memory 202, transmitter 206, receiver 208, control module 210, and/or passenger module 212, etc. to receive, to send, to process information, and/or to control operations of the server 200. The processor 204 may retrieve a set of instructions from a permanent memory device such as a ROM device and copy the instructions in an executable form to a temporary memory device that is generally some form of RAM. The transmitter(s) 206 can transmit and/or send information or data to another device (e.g., another server, media playback devices 108, and/or PEDs 110). The receiver(s) 208 can receive information and/or data transmitted or sent by another device (e.g., another server, media playback devices 108, and/or PEDs 110). The control module 210 of the server 200 can perform operations to assist the IFE system 101, for example, by performing an analysis and/or testing for wireless connections provided in the airplane 100 or other passenger vehicle (e.g., commercial passenger vehicle).

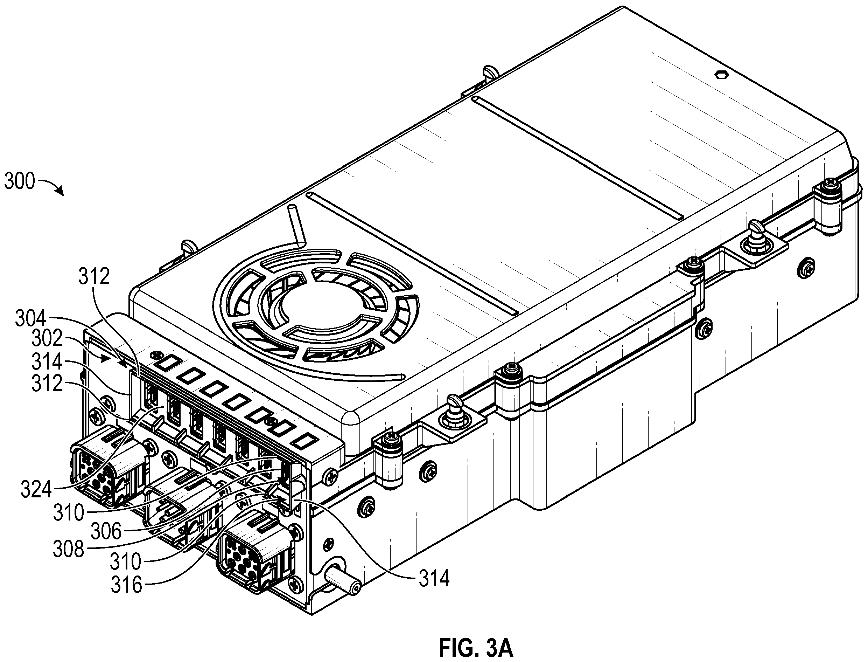

### B. Electronic Box with Connector Boot - FIGS. 3A-6D

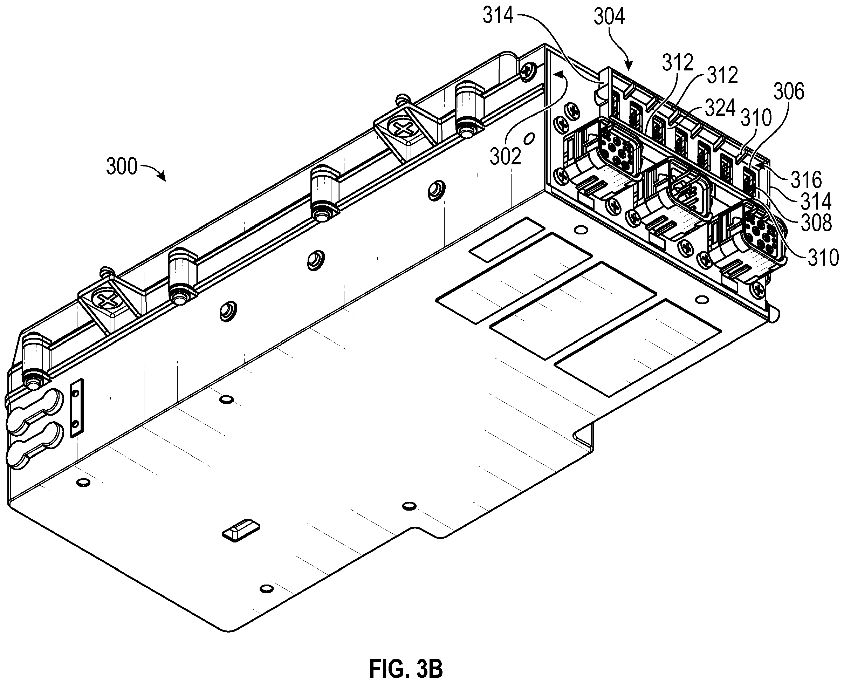

FIGS. 3A and 3B illustrate an electronics box 300 that can be incorporated into an entertainment system of a passenger vehicle (e.g., IFE system 101 of an airplane). The electronics box 300 can include electronic components for supporting the entertainment system such as the IFE system 101. The electronics box 300 can support the use of PEDs 110 and/or media playback device 108. The electronics box 300 can be disposed at various locations throughout the passenger vehicle, such as underneath passenger seats, inside portions of passengers seats, and/or other locations proximate passenger seats.

The electronics box 300 can include a cover plate 302 (e.g., cover, plate, connector plate). The cover plate 302 can include one or more holes through which connector plugs (e.g., IX connector plugs) can interface with connector receptacles 308 of the electronics box 300.

A connector boot 304 (e.g., boot, connector seat) that can be coupled to the electronics box 300. The connector boot 304 can at least reduce the impact of vibration, shock, and/or fluids on the connection between the connector plug and the connector receptacle 308. For example, the connector boot 304 can impede (e.g., prevent, stop, hinder, inhibit) fluids from reaching the interface between the connector plug and the connector receptacle 308. The connector boot 304 can seal the interface between the connector plug and the connector receptacle 308 from fluid ingress. The connector boot 304 can reduce movement between the connector plug and the connector receptacle 308, which can help maintain signal integrity during vibration and/or shock. The connector boot 304 can, at least in part, support (e.g., hold) the connector plug to reduce movement between the connector plug and the connector receptacle 308.

The connector boot 304 can include one or more openings 306 (e.g., seven openings). The openings 306 can correspond in size and/or positioning with the connector receptacles 308 such that, with the connector boot 304 coupled to the cover plate 302, the openings 306 are aligned (e.g., coaxially positioned) with the connector receptacles 308. The openings 306 can be disposed in a base wall 324 (e.g., base surface, surface, wall, base) of the connector boot 304. The base wall 324 can be disposed against the cover plate 302. The base wall 324 can be parallel to the outward facing surface of the cover plate 302. The base wall 324 can be generally flat.

The connector boot 304 can include side walls 312 (e.g., longitudinal side walls, elongate side walls). The side walls 312 can extend outward (e.g., flare outward), which can at least include being angled and/or curved outward, to accommodate the shape of the connector plugs to restrict movement of the connector plugs relative to the connector boot 304 and/or connector receptacle 308. The side walls 312 can include contours that complement the shape of the connector plugs to restrict movement of the connector plugs relative to the connector boot 304 and/or connector receptacle 308. The side walls 312 can extend on longitudinal sides of the connector boot 304. The side walls 312 can extend between end walls 314 of the connector boot 304. The end walls 314, in some aspects, can extend outward (e.g., flare outward), which can at least include being angled and/or curved outward. The side walls 312 and/or end walls 314 can extend (e.g., protrude) from the base wall 324 of the connector boot 304. The base wall 324 can span between the opposing side walls 312. The base wall 324 can span between the opposing end walls 314.

The connector boot 304 can include partitions 310 (e.g., walls, internal walls, internal partitions, dividers, barriers). The partitions 310 can be disposed between adjacent openings 306 of the connector boot 304. The partitions 310 can be disposed between adjacent connector receptacles 308. The partitions 310 can be disposed between adjacent receiving regions 316 that receive the bodies of the connector plugs.

The partitions 310 can protrude inward from the side walls 312. Between adjacent openings 306, one partition 310 can protrude inward from one side wall 312 and another partition 310 can protrude inward from another side wall 312. The partitions 310 can protrude inward from opposing positions on the side walls 312. The partitions 310 can protrude inward from the side walls 312 toward each other. The partitions 310 can protrude inward to positions between the side walls 312. The partitions 310 can protrude inward to free ends, which can be angled free ends. The partitions 310 can extend (e.g., protrude) from the base wall 324. The partitions 310 can extend (e.g., protrude) from the base wall 324 a distance that is the same as the side walls 312 and/or end walls 314 (e.g., the partitions 310, side walls 312, and/or end walls 314 can have the same height relative to the base wall 324). The partitions 310 can be disposed between adjacent receiving regions 316 of the connector boot 304. The partitions 310 can separate adjacent receiving regions 316 of the connector boot 304. The receiving regions 316 can be configured to receive connector plugs. The receiving regions 316 disposed at ends of the connector boot 304 can be disposed between opposing side walls 312 and between one end wall 314 and a pair of opposing partitions 310. The receiving regions 316 disposed inward from the ends can be disposed between opposing side walls 312 and between adjacent pairs of opposing partitions 310. The partitions 310, side walls 312, and/or end walls 314 can cooperate to restrict movement of connector plugs received in the receiving regions 316 of the connector boot 304.

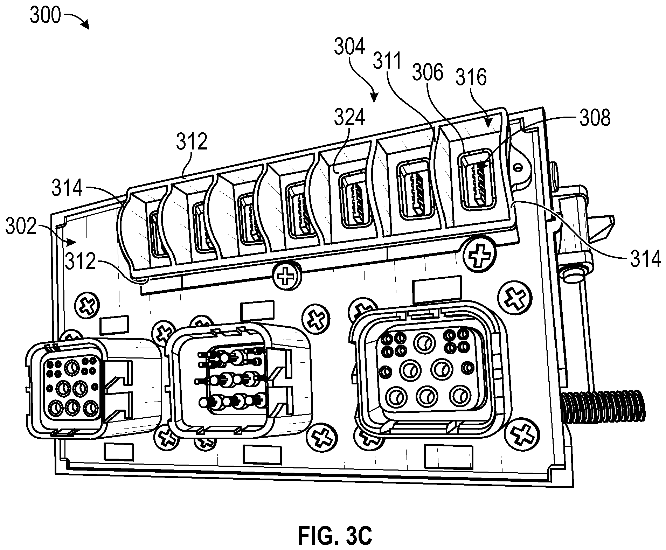

As illustrated in FIG. 3C, in some variants, a partition 311 (e.g., wall, internal wall, internal partition, divider) that spans between the opposing side walls 312 can be disposed between adjacent openings 306 of the connector boot 304. The partition 311 can extend from one of the side walls 312 to the other of the side walls 312. The partition 311 can extend (e.g., protrude) from the base wall 324 of the connector boot 304 to define an edge (e.g., contour, periphery, border) having a curved shape (e.g., arcuate, rounded). The curved shape can be positioned between the opposing side walls 312. In some aspects, the end walls 314 can extend (e.g., protrude) from the base wall 324 of the connector boot 304 to define an edge (e.g., contour, periphery, border) having a curved shape (e.g., arcuate, rounded). The curved shape can be positioned between the opposing side walls 312. In some aspects, the curved shapes of the partition 311 and the end walls 314 can be the same. The partitions 311, similar to the partitions 310, can separate adjacent receiving regions 316 of the connector boot 304. The receiving regions 316 disposed at ends of the connector boot 304 can be disposed between opposing side walls 312 and between one end wall 314 and a partition 311. The receiving regions 316 disposed inward from the ends can be disposed between opposing side walls 312 and between adjacent partitions 311. The partitions 311, side walls 312, and/or end walls 314 can cooperate to restrict movement of connector plugs received in the receiving regions 316 of the connector boot 304.

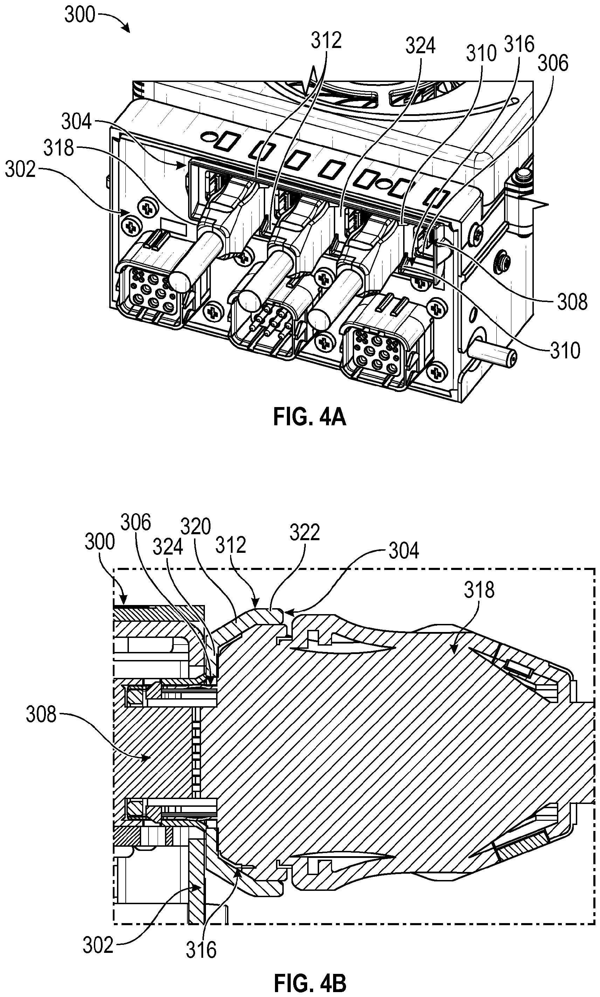

FIG. 4A illustrates connector plugs 318 (e.g., IX connector plugs) interfacing with (e.g., received by) connector receptacles 308 of the electronics box 300. The connector plugs 318 (IX connector plug) can be positioned in receiving regions 316 of the connector boot 304. As illustrated in FIG. 4B, the connector plugs 318 (e.g., IX connector plug) can extend through the openings 306 of the connector boot 304. The connector boot 304 can restrict movement of the connector plugs 318, which can include relative movement between the connector plugs 318 and the connector plugs 318. As illustrated, the side walls 312 can be shaped to accommodate the shape of the connector plugs 318. For example, the side walls 312 can include an angled portion 320 and/or a portion 322 that can correspond to the geometry of the connector plugs 318. The angled portion 320 can extend away from the base wall 324 (e.g., longitudinal side of the base wall 324) at an angle. The angle can be acute. The angle can be less than 30, 35, 40, 45, 50, 55, 60, 65, 70, 75, 80, or more than 80 degrees or any angle between the foregoing. The portion 322 can extend away from the angled portion 320 (e.g., end of the angled portion 320). The portion 322 can be generally perpendicular relative to the base wall 324. In some aspects, the side walls 312 can interface with the connector plugs 318, which can reduce movement of the connector plugs 318.

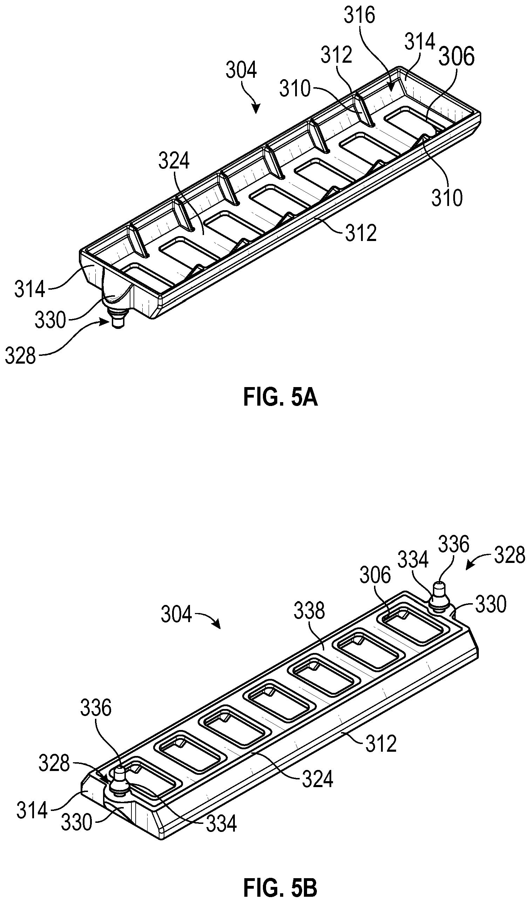

The connector boot 304 can be coupled to the cover plate 302 of the electronics box 300 by way of a variety of techniques. For example, the connector boot 304 can include features to snap-fit the connector boot 304 onto the cover plate 302. As illustrated in FIGS. 5A and 5B, the connector boot 304 can include one or more snap-fit features 328. The snap-fit features 328 can be disposed on opposing ends of the connector boot 304. The snap-fit features 328 can extend (e.g., protrude) from bases 330 (e.g., mounts, feet) of the connector boot 304. The bases 330 can be disposed on opposing ends of the connector boot 304. The bases 330 can protrude outward from the end walls 314. The snap-fit features 328 can protrude in a direction opposite of the side walls 312, end walls 314, partitions 310, and/or partition 311. The snap-fit features 328 can include a protrusion 336 (e.g., projection). The protrusion 336 can include an enlarged portion 334, which can include a tapered profile. The protrusion 336 can include a smaller profile on either side of the enlarged portion 334 relative to the enlarged portion 334. In some aspects, as illustrated in FIG. 5B, adhesive, such as the adhesive component 338 (e.g., tape, double sided adhesive tape, adhesive strip), can be disposed on a backside of the base wall 324 of the connector boot 304 to adhere the connector boot 304 to the cover plate 302.

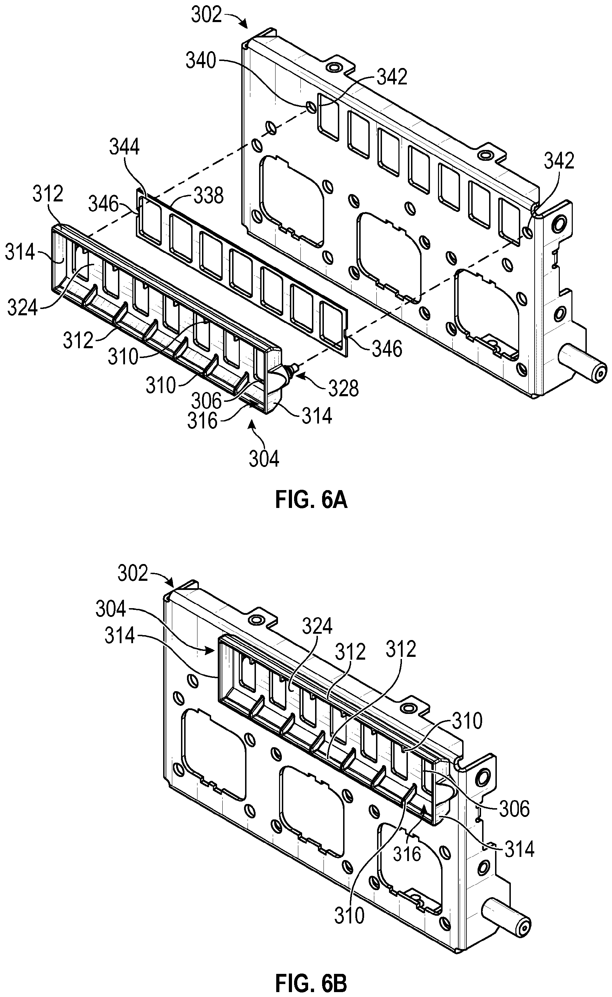

As illustrated in FIG. 6A, the cover plate 302 can include apertures 340 (e.g., holes) that correspond to the snap-fit features 328. In use, the adhesive component 338 can be applied to a backside of the base wall 324. The adhesive component 338 can include openings 344 that correspond to the openings 306 of the connector boot 304. The adhesive component 338 can include notches 346 (e.g., cutouts) to accommodate for the snap-fit features 328. With the adhesive component 338 disposed (e.g., adhered) to the backside of the connector boot 304. The snap-fit features 328 can be inserted into the apertures 340 of the cover plate 302. The protrusions 336 can be inserted into the apertures 340 and advanced until the enlarged portions 334 of the protrusions 336 passes through the apertures 340, securing the connector boot 304 to the cover plate 302 with a snap-fit. As described herein, the enlarged portions 334 of the protrusions 336 can be tapered to facilitate a snap-fit. The adhesive component 338 can adhere the connector boot 304 to the cover plate 302. The cover plate 302 can include openings 342 that correspond to the openings 344 of the adhesive component 338 and/or openings 306 of the connector boot 304. The connector receptacles 308 can be accessed through the openings 342 of the cover plate 302. In some aspects, adhesive (e.g., adhesive component 338) is not used to couple the connector boot 304 to the cover plate 302. The snap-fit features 328 and/or adhesive component 338 can facilitate efficient installation of the cover plate 302.

In some aspects, adhesive (e.g., adhesive component 338) is used to couple the connector boot 304 to the cover plate 302 without snap-fit features 328, which can include being used alone or with other fastening techniques. In some aspects, a release liner can be disposed on the adhesive component 338 until the connector boot 304 is ready for use. In some aspects, as illustrated in FIG. 6B, the connector boot 304 can be over-molded onto the cover plate 302. In some aspects, the connector boot 304 can be coupled to the cover plate 302 with fasteners, such as screws, bolts, brackets, clips, staples, ties, links, and/or other features.

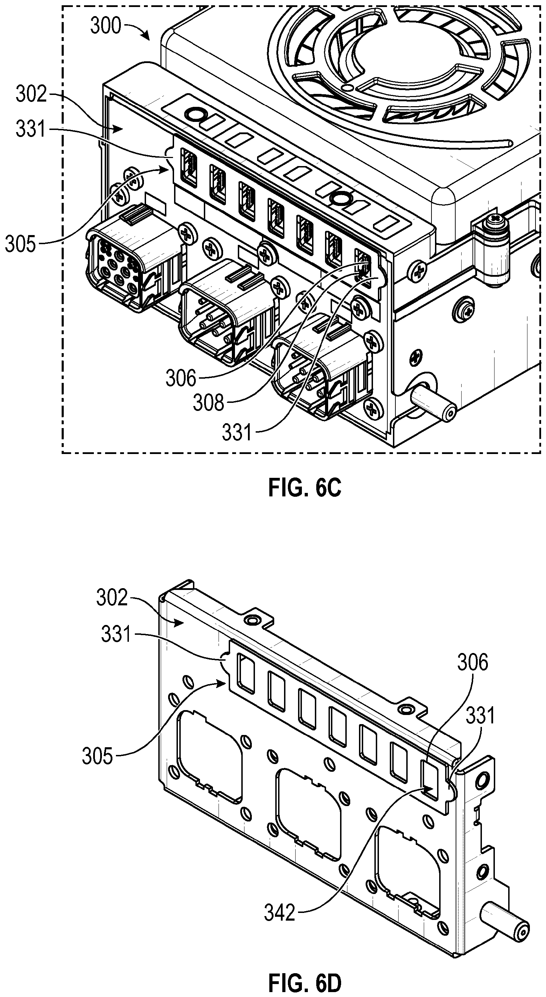

FIGS. 6C and 6D illustrates a connector boot 305 (e.g., boot, connector seat) that can be coupled to the electronics box 300. The connector boot 305 can include any of the features described in reference to the connector boot 304. The connector boot 305 can provide one or more of the benefits described in reference to the connector boot 304. The connector boot 305 can be coupled to the cover plate 302 of the electronics box 300 using at least the techniques described herein, which can at least include the use of adhesive (e.g., an adhesive component), snap-fit feature(s), fastener(s) (e.g., screws, clips, pins, rivets, etc.), and or other techniques.

The connector boot 305 can include one or more openings 306 (e.g., seven openings). The openings 306 can correspond in size and/or positioning with the connector receptacles 308 such that, with the connector boot 305 coupled to the cover plate 302, the openings 306 are aligned (e.g., coaxially positioned) with the connector receptacles 308. As illustrated in FIG. 6D, the one or more openings 306 can be aligned (e.g., coaxially positioned) with the one or more openings 342 of the cover plate 302.

The connector boot 305 can include one or more projections 331 (e.g., flanges). The projections 331 can be disposed on opposing ends of the connector boot 305, which can include projecting from opposing ends of the connector boot 305. In some variants, the one or more projections 331 can include snap-fit features on a side facing the cover plate 302. The one or more projections 331 can be rounded, which can include having a semi-circle shape. The one or more projections 331 can include a rounded profile.

The connector boot 305 can at least reduce the impact of vibration, shock, and/or fluids on the connection (e.g. interface) between the connector plugs 318 and the connector receptacles 308. The connector boot 305 can be compressed between the connector plugs 318 and cover plate 302, which can reduce the ingress of liquid and/or impact of shock and/or vibration. The connector boot 305, in some variants, can omit the side walls and/or partitions described in reference to the connector boot 304. The connector boot 305 can include a generally rectangular shape, which can include having rounded corners.

The connector boot 304 and/or 305 can be made of a variety of materials, which can at least include polymers (e.g., rubber), metals, metal alloys, composites, and/or others. The connector boot 304 and/or 305 can be made using a variety of techniques, which can at least include molding, casting, machining, 3D printing, and/or other techniques.

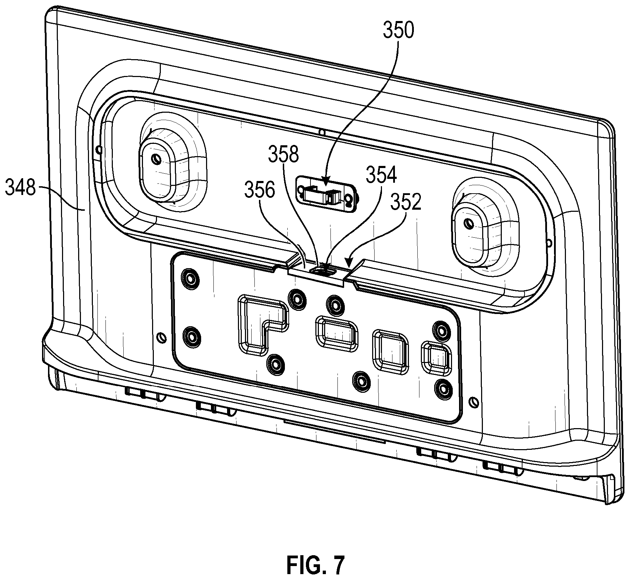

### C. Cushion Component - FIGS. 7-9B

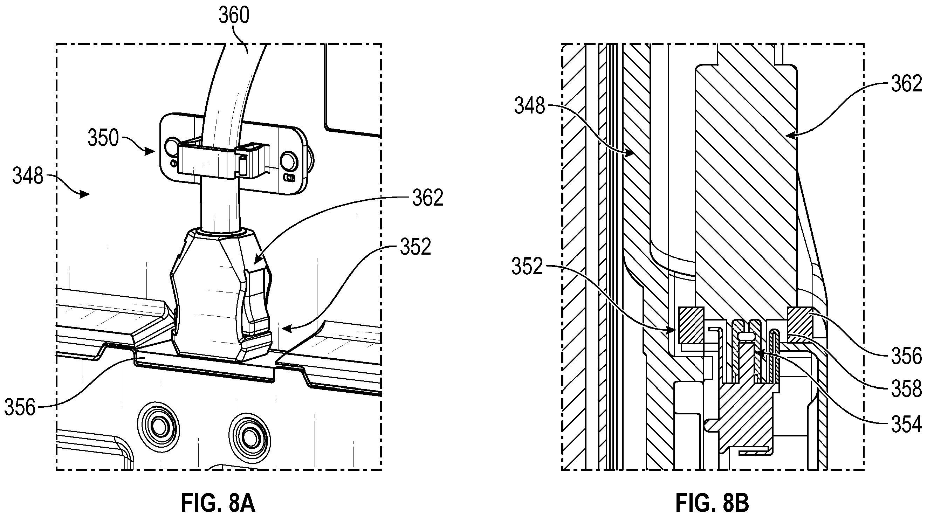

As illustrated in FIG. 7-8B, a connector receptacle 354 for a display (e.g., monitor) in an entertainment system (e.g., IFE entertainment system) can face upwards, which can be susceptible to fluid ingress to the connector receptacle 354 and/or interface between the connector receptacle 354 and the connector plug. A sealing component 356 (e.g., cushion, pad, pad component, sealing cushion, sealing component, cushion component, deflectable component) can impede (e.g., prevent, stop, hinder, inhibit) fluids from reaching the interface between a connector plug and the connector receptacle 354. The sealing component 356 can be disposed in a recess 352 (e.g., cutout, groove) of the display housing 348 (e.g., monitor housing) surrounding the connector receptacle 354. The sealing component 356 can include an opening 358 through which the connector receptacle 354 can be accessed. The sealing component 356 can be coupled to the display housing 348, which can include being adhered to the display housing 348 (e.g., adhered using tape, such as double sided adhesive tape). As illustrated in FIGS. 8A and 8B, the connector plug 362 (e.g., IX connector plug) can compress the sealing component 356 when interfacing with the connector receptacle 354, which can form a seal between the connector plug 362 and the display housing 348 (e.g., portions of the display housing 348 surrounding the connector receptacle 354) to impede fluids from reaching the connector receptacle 354 and/or interface between the connector plug 362 and connector receptacle 354. As illustrated in FIGS. 8A and 8B, a clip 350 (e.g., clasp, catch) can restrain movement of the cable 360 of the connector plug 362, which can reduce relative movement between the connector plug 362 and connector receptacle 354 and/or reduce stress to improve signal integrity during vibration and/or shock.

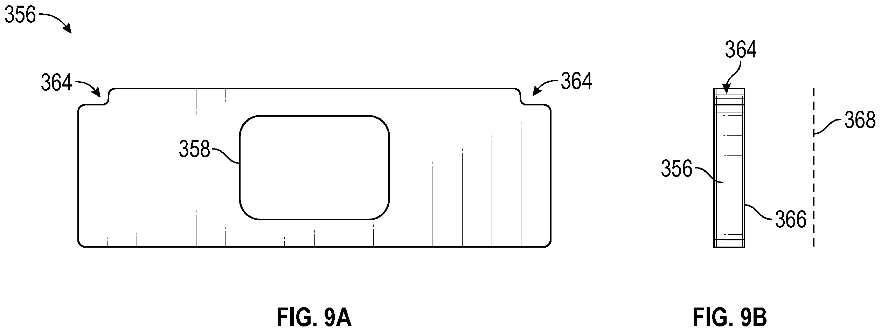

As illustrated in FIG. 9A, the sealing component 356 can have a generally rectangular shape. The sealing component 356 can have notches 364 (e.g., cutouts) at two corners, which can accommodate for the features of the display housing 348. As illustrated in FIG. 9B, an adhesive 366 can be disposed on one side of the sealing component 356 to adhere the sealing component 356 to the display housing 348. A release liner 368 can be disposed on the adhesive 366 to cover the adhesive 366 until the sealing component 356 is ready for use. In use, the release liner 368 can be removed to expose the adhesive 366. The sealing component 356, with the adhesive 366 exposed, can be adhered to the display housing 348 with the opening 358 aligned (e.g., coaxially positioned) with the connector receptacle 354. The connector plug 362 can interface with the connector receptacle 354 compressing the sealing component 356 to create a seal.

The sealing component 356 can be made of a variety of materials, which can at least include foam (e.g., poron foam), polymers (e.g., rubber), and/or others. The sealing component 356 can be made using a variety of techniques, which can at least include die cutting, molding, casting, machining, 3D printing, and/or other techniques. In some aspects, the sealing component 356 can be die cut from foam.

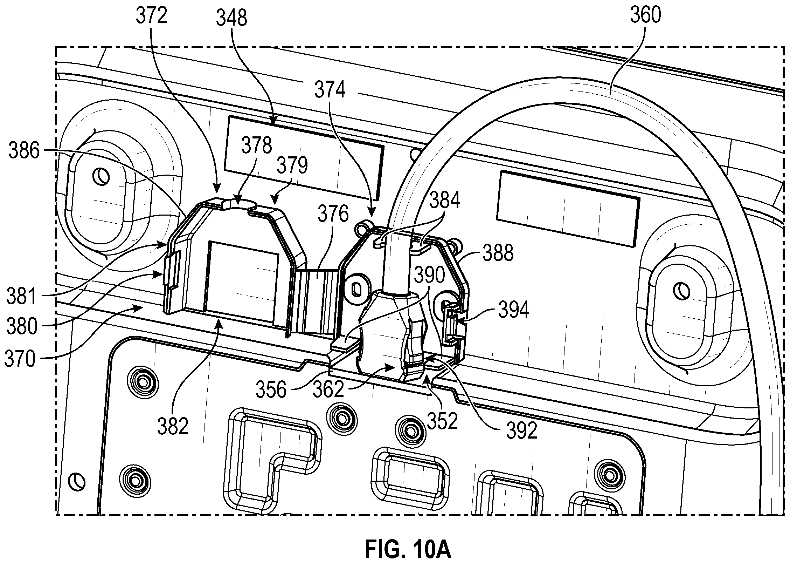

### D. Enclosure for Connector Plug - FIGS. 10A-12B

FIG. 10A illustrates an enclosure 370 (e.g., enclosure component, fluid diverter, housing, compartment, water diverter, water diverter clip) in an open configuration. The enclosure 370 can be disposed over (e.g., enclose, cover) at least a portion of the connector plug 362. The enclosure 370 can impede (e.g., prevent, stop, hinder, inhibit) fluids from entering small openings in the housing of the connector plug 362. The enclosure 370 can restrain (e.g., clamp) the connector plug 362 and/or cable 360, which can reduce relative movement between the connector plug 362 and connector receptacle 354 and/or reduce stress to improve signal integrity during vibration and/or shock. The enclosure 370 can include a periphery that tapers in width such that a top of the enclosure 370 (e.g., side of the enclosure 370 from which the cable 360 exits) is smaller than a bottom. The enclosure 370 can have a portion (e.g., bottom portion) with a periphery having a consistent width and a top with a periphery that tapers.

The enclosure 370 can include a base 374 that can be coupled (e.g., fastened, fastened with screws, adhered) to the display housing 348. The enclosure 370 can include a cover 372 that can be rotatably coupled to the base 374. For example, the enclosure 370 can include a hinge 376 (e.g., living hinge) coupling the base 374 and the cover 372. The cover 372 can be rotated open to provide access into an interior (e.g., interior cavity, interior space) of the enclosure 370. The cover 372 can be rotated closed to shut the enclosure 370, which can enclose the connector plug 362 within the interior of the enclosure 370.

The cover 372 can include a peripheral wall 386. The peripheral wall 386 can extend around the periphery of the cover 372. The cover 372 can include an opening 382 (e.g., gap), which can be gap in the peripheral wall 386. The opening 382 can be disposed at a bottom of the cover 372, which can be opposite from where the cable 360 exits the enclosure 370. The opening 382 can, in some variants, span the entire bottom side of the cover 372. The connector plug 362, when disposed in the enclosure 370, can interface with the connector receptacle 354 through the opening 382.

The base 374 can include a ledge 388 (e.g., shelf, groove, channel, space, surface) that corresponds to the peripheral wall 386. The ledge 388 can receive the peripheral wall 386 when the cover 372 is rotated shut. The ledge 388 and peripheral wall 386 can have complementary shapes, which can be the same shape. The ledge 388 can extend around the periphery of the base 374. In some variants, the peripheral wall 386 and ledge 388 can overlap to help impede the ingress of fluids into the closed enclosure 370. In some variants, the cover 372 can include the ledge 388 and the base 374 can include the peripheral wall 386.

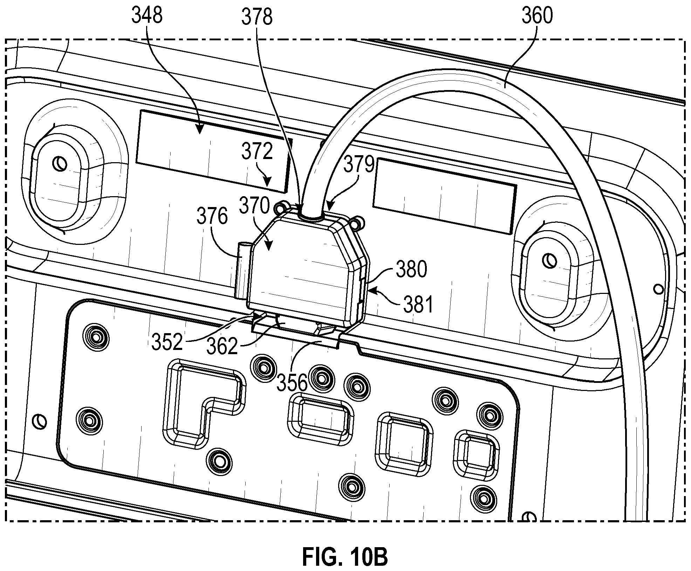

The enclosure 370 can include an integrated cable clip 379 (e.g., integrated cable retainer, cable clasp, cable catch). The integrated cable clip 379 can restrain movement of the cable 360 of the connector plug 362, which can reduce relative movement between the connector plug 362 and connector receptacle 354 and/or reduce stress to improve signal integrity during vibration and/or shock. The integrated cable clip 379 can include features of the base 374 and/or cover 372 that, with the cover 372 closed, retain (e.g., clamp) the cable 360, as illustrated in FIG. 10B. For example, as shown in FIG. 10A, the base 374 can include a flange 384 (e.g., projection, prong, fork) that can receive the cable 360 of the connector plug 362. For example, the flange 384 can include a groove, channel, cutout, recess, etc. that can receive the cable 360. The cover 372 can include a channel 378 (e.g., groove, recess, cutout) in the peripheral wall 386 (e.g., top of the peripheral wall 386). In some variants, the channel 378 can protrude beyond the profile of the peripheral wall 386. With the cover 372 closed, the channel 378 can be disposed over the cable 360, retaining (e.g., clamping, clipping) the cable 360 between the channel 378 (e.g., portion of the peripheral wall 386 defining the channel 378) and the flange 384 (e.g., groove, channel, cutout, recess, etc. of the flange 384), as illustrated in FIG. 10B. With the cover 372 closed, the cable 360 can be disposed between the channel 378 in the peripheral wall 386 of the cover 372 and the flange 384 (e.g., groove, fork, channel, cutout, etc. of the flange 384) to retain (e.g., clamp) the cable 360.

The base 374 can include flanges 390 (e.g., walls, barriers). The flanges 390 can be disposed at a bottom (e.g., opposite the flange 384) of the base 374. The flanges 390 can be spaced apart by a gap 392 through which the connector plug 362 can be disposed to interface with the connector receptacle 354. The flanges 390 can help impede the ingress of fluid or other unwanted matter into the closed enclosure 370 from a bottom side. With the cover 372 closed, the flanges 390 can span at least a portion of the opening 382 of the cover 372. In some variants, the flanges 390 can be disposed on the cover 372 instead of the base 374. In some variants, one of the flanges 390 can be disposed on the cover 372 and one on the base 374.

The enclosure 370 can include features to releasably lock the cover 372 in the closed configuration (e.g., releasably lock the cover 372 to the base 374 to prevent inadvertent opening). For example, the enclosure 370 can include a locking mechanism 381 (e.g., clip, latch, retainer, catch, lock) to retain the cover 372 in the closed configuration. The locking mechanism 381 can include features of the base 374 and/or cover 372 that releasably lock the cover 372 to the base 374 in the closed configuration. The base 374 can include a catch 394 (e.g., edge, hook, clip, surface, member). The catch 394 can be disposed at a periphery of the base 374. The cover 372 can include a deflectable member 380 (e.g., edge, hook, clip, surface, member). The deflectable member 380 can be disposed at the peripheral wall 386. The deflectable member 380 can interface (e.g., couple to, engage with, clip onto) the catch 394 to retain the cover 372 on the base 374 in the closed configuration. In some variants, the deflectable member 380 can contact and deflect around the catch 394 as the cover 372 is being closed to interface the deflectable member 380 and the catch 394 to retain the cover 372 in the closed configuration. To release the cover 372, a user can apply a force (e.g., push with a finger) inward (e.g., toward the interior of the enclosure 370) on the catch 394 to free the deflectable member 380 from the catch 394 so that the cover 372 can be rotated open. In some variants, a user can manipulate the deflectable member 380 to uncouple from the catch 394 so that the cover 372 can be rotated open. In some variants, the base 374 can include the deflectable member 380 and the cover 372 can include the catch 394.

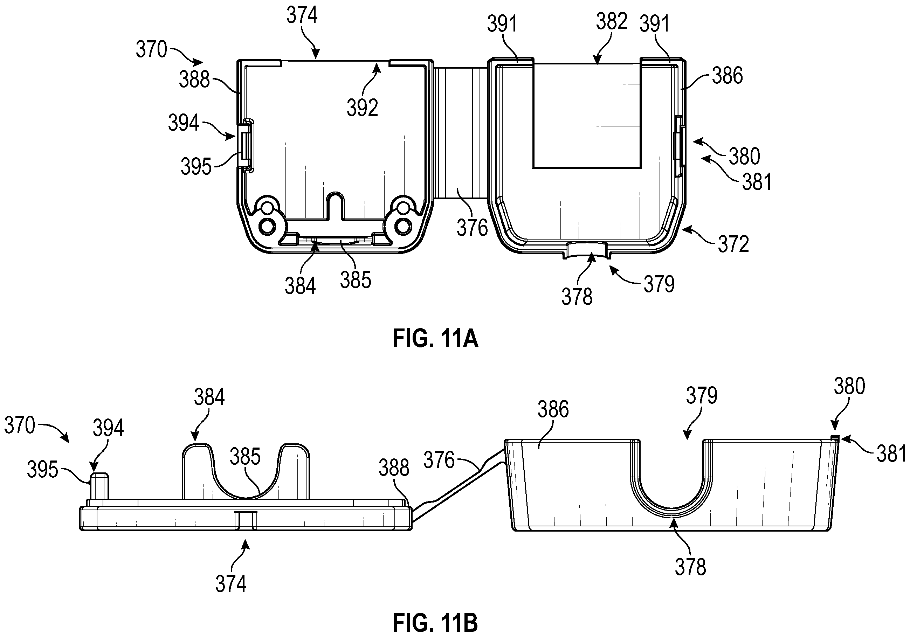

FIG. 11A illustrates an example of the enclosure 370 in an open configuration. A shown, in some variants, the ledge 388 can extend around the periphery of the base 374. The ledge 388 can include a gap 392 along the bottom side of the base 374, which can provide room for the connector plug 362 to interface with the connector receptacle 354.

The flange 384 can include a channel 385 (e.g., groove, fork, cutout, recess) that can receive the cable 360. The channel 385 can include a generally round shape. The flange 384 can be disposed inward of the ledge 388. The flange 384 can be disposed proximate a top of the enclosure 370 (e.g., side of the enclosure 370 through which the cable 360 exits).

The catch 394 can include an edge 395 (edge, hook, clip, surface, member). In some variants, the deflectable member 380 can deflect around and behind the edge 395 to couple the catch 394 and deflectable member 380 together. In some variants, the edge 395 of the catch 394 can deflect around and behind the deflectable member 380 to couple the catch 394 and the deflectable member 380 together.

In some variants, the peripheral wall 386 can include bottom portions 391 (e.g., walls, barriers). The bottom portions 391 can span at least a portion of the bottom side (e.g. side of the enclosure 370 through which the connector plug 362 extends to interface with the connector receptacle 354). The bottom portions 391 can be separated by an opening 382 through which the connector plug 362 extends to interface with the connector receptacle 354.

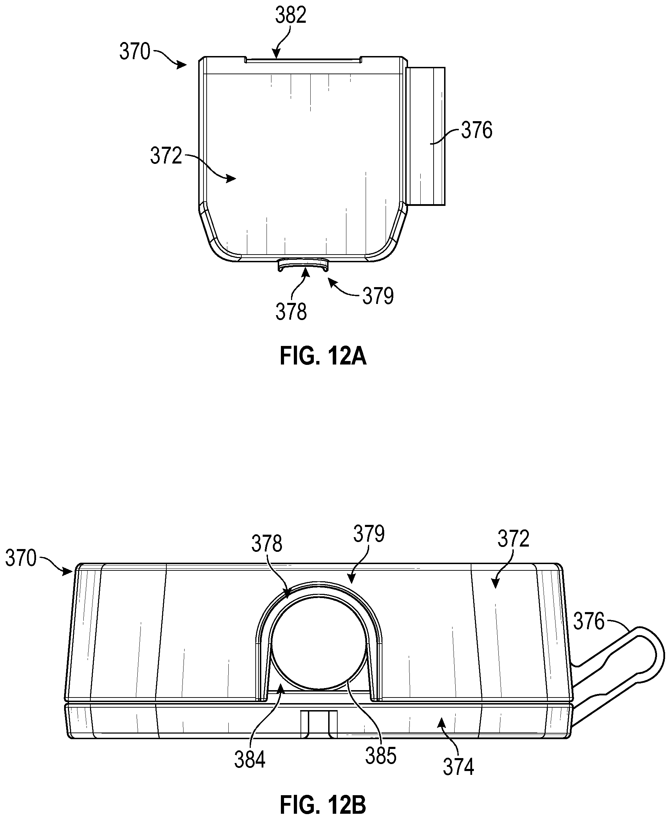

FIGS. 12A and 12B illustrate an example of the enclosure 370 in the closed configuration (e.g., with the cover 372 releasably coupled to the base 374). As illustrated in FIG. 12B, with the enclosure 370 in the closed configuration, the integrated cable clip 379 can be in a clamping configuration to secure the cable 360 of the connector plug 362. For example, the channel 385 of the flange 384 and the channel 378 of the cover 372 can cooperate to clamp around the cable 360 from opposing sides, which can include forming a circular (e.g., round) aperture through which the cable 360 extends. The channel 385 of the flange 384 can contact one side of the cable 360 and the channel 378 of the cover 372 can contact the other side of the cable 360 to secure the cable 360.

In use, the base 374 of the enclosure 370 can be coupled (e.g., adhered, fastened, coupled with screws, etc.) to the display housing 348, which can be proximate the connector receptacle 354. In some variants, the sealing component 356 can be disposed (e.g., adhered) around the connector receptacle 354, which can include prior to or after coupling the base 374 to the display housing 348. The connector plug 362 can be maneuvered to interface with the connector receptacle 354 through the gap 392 between the flanges 390 of the base 374. The cable 360 of the connector plug 362 can be disposed in the channel 385 of the flange 384 of the base 374. The cover 372 can be rotated by way of the hinge 376 to a closed configuration to enclose the connector plug 362 and a portion of the cable 360 within an interior of the enclosure 370. The channel 378 of the cover 372 (e.g., the channel 378 in the peripheral wall 386) can be disposed around the connector plug 362. The channel 378 of the cover 372 and the channel 385 of the flange 384 can form an integrated cable clip 379 that clamps around the cable 360 to restrict movement of the cable 360. The locking mechanism 381 of the enclosure 370 can retain the enclosure 370 in the closed configuration. For example, the deflectable member 380 of the cover 372 and the catch 394 of the base 374 can engage to releasably couple the cover 372 to the base 374 in the closed configuration.

The enclosure 370 can be formed with a variety of materials, which can at least include metals, metal alloys, polymers (e.g., plastic), etc. The enclosure 370 can be formed with a variety of techniques, which can include injection molding (e.g., plastic injection molding).

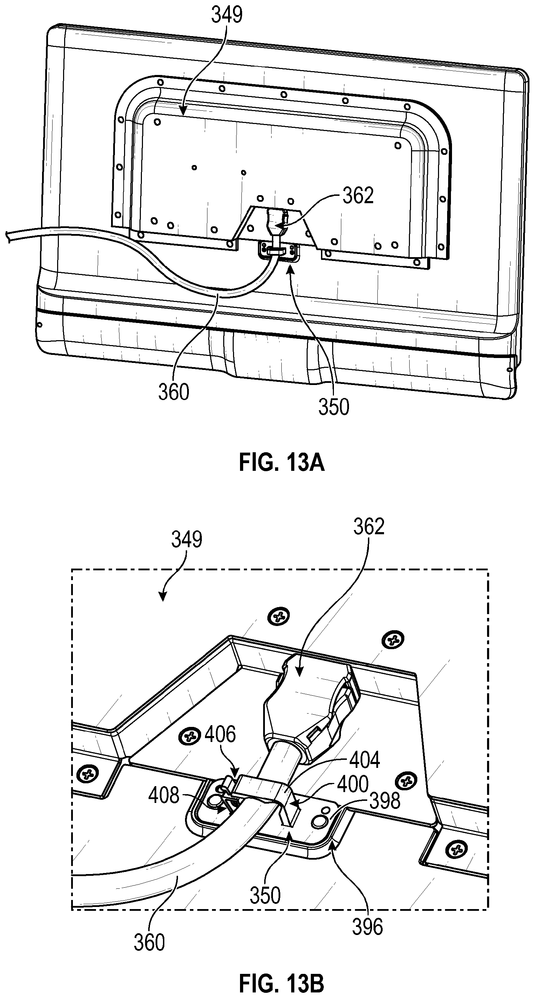

### E. Clip - FIGS. 13A-14B

FIGS. 13A and 13B illustrate a clip 350 (e.g., clasp, catch, latch) for retaining the cable 360 of the connector plug 362. As shown, in some variants, the connector receptacle for a display (e.g., monitor) in an entertainment system (e.g., IFE entertainment system) can face downwards, which can be less susceptible to fluid ingress into the connector receptacle and/or interface between the connector receptacle and the connector plug 362 compared to an upward-facing connector receptacle. Accordingly, in some variants, a sealing component 356 and/or enclosure 370 may be omitted for downward facing connector receptacles, as shown in FIGS. 13A and 13B. In some variants, sealing component 356 and/or enclosure 370 may be used with downward facing connector receptacles.

As shown in FIG. 13B, the clip 350 can include a base plate 398 that can be coupled (e.g., adhered, coupled with screws, fastened) to the display housing 349 and/or structures proximate the display housing 349. In some variants, the display housing 349 and/or structure proximate the display housing 349 can include a boundary wall 396 (e.g., lip, edge) around the location where the base plate 398 is coupled to the display housing 349 and/or structure proximate the display housing 349. The boundary wall 396 can include a curvature that slopes up to an outward facing surface of the base plate 398.

The clip 350 can include a deflectable member 400 (e.g., bendable member, hook, clip). The deflectable member 400 can extend away from the base plate 398. The deflectable member 400 can include a hinge 404, which can be a living hinge. The hinge 404 can be a portion of the deflectable member 400 with a reduced thickness. For example, the thickness of the deflectable member 400 on either side of the hinge 404 can be greater. In some variants, the thickness of the deflectable member 400 can gradually reduce approaching the hinge 404 and gradually increase leaving the hinge 404.

The deflectable member 400 can include a locking end 406 (e.g., anchor, spring lock, lock, locking mechanism, spring anchor). The deflectable member 400 can be deflected (e.g., bent) by way of the hinge 404 to engage the locking end 406 with a catch 408 (e.g., retaining edge, retaining hook), which can be disposed on the base plate 398. The cable 360 of the connector plug 362 can be restrained between the base plate 398 and the deflectable member 400 with the locking end 406 of the deflectable member 400 engaged with the catch 408, as illustrated in FIG. 13B.

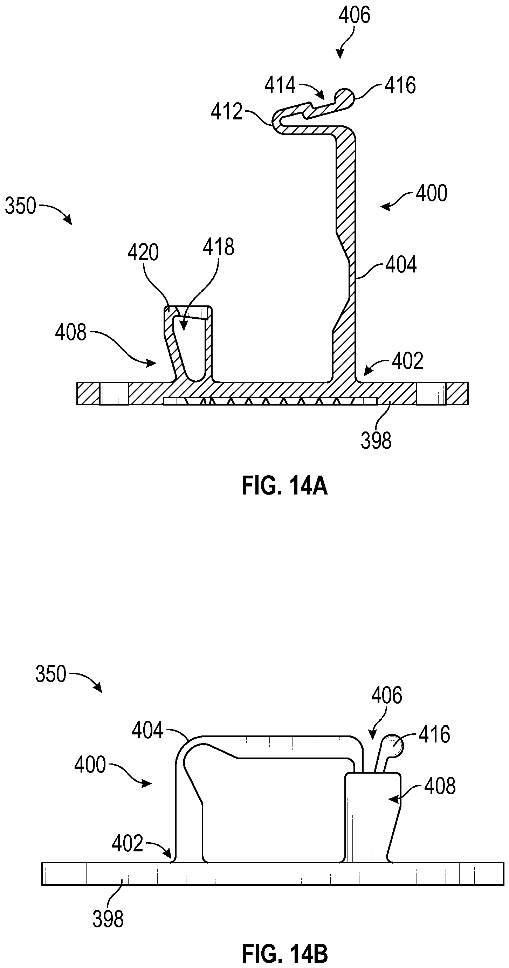

FIG. 14A illustrates a cross-sectional view of the clip 350 in an open configuration (e.g., with the locking end 406 disengaged from the catch 408). As shown, the locking end 406 can include a "V" or "U" shape. The locking end 406 can include a bend 412 and/or angle that biases the locking end 406 into a configuration (e.g., open configuration). The locking end 406 can include a recess 414 that can releasably engage with a hook 420 (e.g., edge, ledge, overhang) of the catch 408 to restrain the deflectable member 400 in the deflected configuration to secure the cable 360. For example, the locking end 406 can be maneuvered into a cavity 418 (e.g., interior) of the catch 408. The bend 412 of the locking end 406 can be advanced into the cavity 418. The hook 420 of the catch 408 can push against the locking end 406 causing the locking end 406 to deflect (e.g., deflect to narrow the V or U shape of the locking end 406, deflect in a direction of closing the V or U shape of the locking end 406) by way of the bend 412. When the hook 420 reaches the recess 414 of the locking end 406, the bend 412 of the locking end 406 can spring (e.g., force, push, snap) the recess 414 to engage the hook 420, which can hold the deflectable member 400 in the locked configuration (e.g., bent configuration, deflected configuration) as illustrated in FIG. 14B. The locking end 406 can be retained in the cavity 418 of the catch 408. The locking end 406 of the deflectable member 400 can include an end portion 416 (e.g., enlarged portion, rounded end, bulb) that a user can manipulate to disengage (e.g., release) the locking end 406 from the catch 408. For example, the user can push the end portion 416 inward (e.g., in a direction toward closing the V or U shape) to further deflect the locking end 406, which can disengage the recess 414 of the locking end 406 and the hook 420 of the catch 408 to return the clip 350 to the open configuration illustrated in FIG. 14A.

In use, the base plate 398 of the clip 350 can be coupled to the display housing 349 and/or surrounding structure. In some variants, the base plate 398 can be disposed within a boundary wall 396 of the display housing 349 and/or surrounding structure. The connector plug 362 can be maneuvered to interface with the connector receptacle, which can be downward facing, for the display housing 349. The cable 360 of the connector plug 362 can be disposed between the deflectable member 400 and the catch 408. The deflectable member 400 can be deflected by way of the hinge 404 to engage the locking end 406 with the catch 408. For example, the recess 414 of the locking end 406 can engage with the hook 420 of the catch 408. The locking end 406 can be biased to lock the recess 414 and the hook 420 together. The cable 360 can be restrained between the deflectable member 400, base plate 398, and catch 408.

The clip 350 can be formed with a variety of materials, which can at least include metals, metal alloys, polymers (e.g., plastic), etc. The clip 350 can be formed with a variety of techniques, which can include injection molding (e.g., plastic injection molding).

### F. Improving Connector Plug's Resistance to Fluid with Foil - FIGS. 15A-15E

FIGS. 15A-15E illustrate a method of improving the resistance of a connector plug 362 to fluids with foil, which can be made of a variety of materials such as metal (e.g., copper), metal alloys, and/or others. The foil can help prevent shorting internal wire connections. The method can be applied to connector plugs throughout the entertainment system (e.g., IFE system).

FIG. 15A illustrates the connector plug 362 with the outer components removed to expose the insulation-displacement connector (IDC) unit 422, wire guide 424, and wires 426. The wire guide 424 can guide the wires 426 from the inside of the cable 360 to the IDC unit 422.

As shown in FIG. 15B, foil wrap 428 (e.g., copper foil, copper foil wrap, foil, copper tape) can be disposed around at least a portion of the IDC unit 422, the wire guide 424, wires 426, and/or portion of the cable 360. The foil wrap 428 can be electrically conductive, which can facilitate electrical connection between internal components of the plug (e.g., cable shield and connector back shell). The IDC unit 422 and wire guide 424 can be made of a polymer (e.g., plastic), which can reduce or even eliminate risk of shorting the wires 426 with the foil wrap 428. Because the foil wrap 428 is internal, the outer dimensions of the connector plug 362 can remain unchanged.

As shown in FIG. 15C, the shield case 430 can be disposed over the foil wrap 428. The shield shell 432 can then interface with the shield case 430, as shown in FIG. 15D. The cover case 434 can then be disposed over the internal components of the connector plug 362, as shown in FIG. 15E.

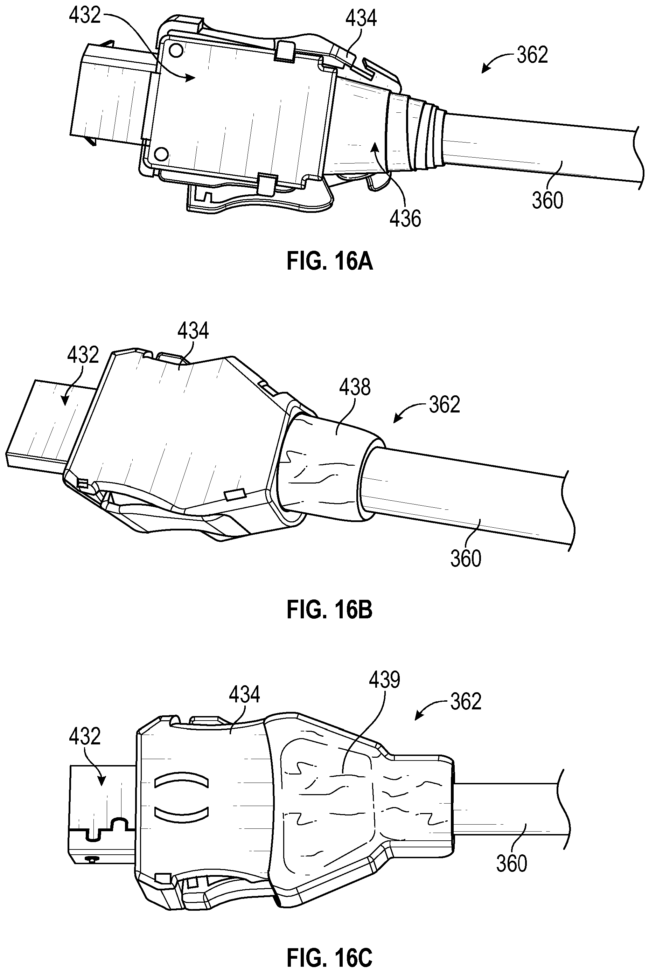

### G. Improving Connector Plug's Resistance to Liquid with Tape and/or Heat Shrink - FIGS. 16A-16C

FIG. 16A illustrates a method of improving the resistance of a connector plug 362 to fluids with tape 436 (e.g., silicone tape). The tape 436 can be wrapped over the internal features of the connector plug 362 at the entry of the cable 360 into the cover case 434. For example, tape 436 can be wrapped around the cable 360, portion of the shield case 430 over the cable 360, and/or wires 426 (e.g., wires 426 wrapped in foil wrap 428). The tape 436 and the features wrapped in tape can be disposed (e.g., sandwiched) between the two sides of the cover case 434 that are coupled together. The tape 436 can impede fluids traveling along the cable 360 from entering into the connector plug 362 through the opening in the cover case 434. As shown in FIG. 16B, heat shrink 438 can be applied over the cable 360 at the entry into the connector plug 362. The heat shrink 438 can impede fluids traveling along the cable 360 from entering into the connector plug 362 through the opening in the cover case 434.

In use, the cover case 434 of the connector plug 362 can be removed. The internal features of the connector plug 362 proximate the cable 360 and/or portion of the cable 360 proximate the connector plug 362 can be wrapped in tape 436. The cover case 434 can be applied to the connector plug 362, which can squeeze the tape 436 and/or features wrapped in the tape 436 between the two sides of the cover case 434. Heat shrink 438 can be applied over the portion of the cable 360 at the entry into the connector plug 362. The heat shrink 438 can be heated. In some variants, heat shrink 438 can be applied over the portion of the cover case 434 proximate the cable 360, as shown in FIG. 16C, which may slightly increase the outer dimensions of the cover case 434 (e.g., increase by about 1.1 millimeters).

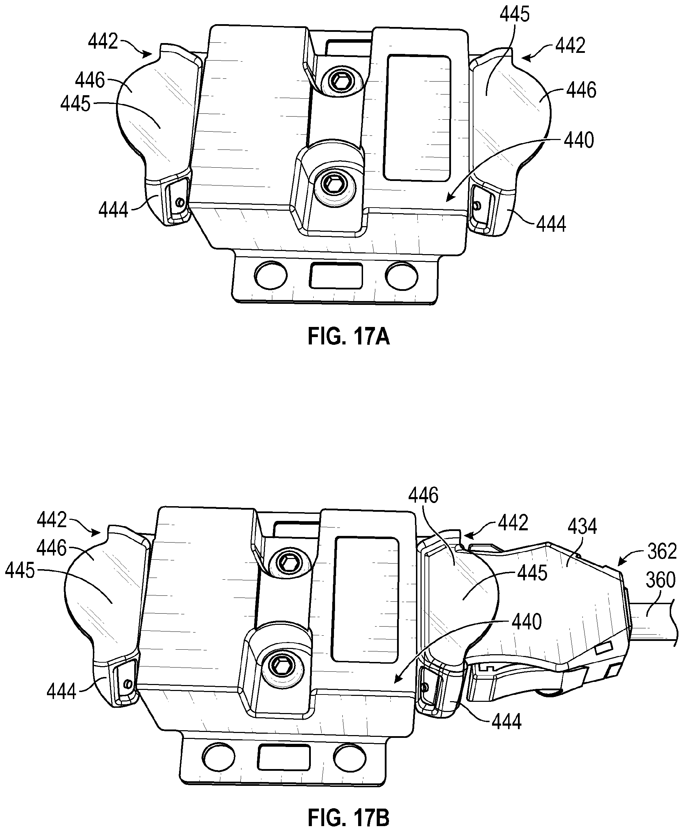

### H. In-line Disconnect Box with Connector Boots - FIGS. 17A and 17B

FIGS. 17A and 17B illustrate connector boots 442 (e.g., boot, connector seat) that can be incorporated into an in-line disconnect box 440. The connector boot 442 can be coupled to the in-line disconnect box 440, which can include coupling by way of adhesive (e.g., double-sided adhesive tape). The connector boots 442 can at least reduce the impact of vibration, shock, and/or fluids on the connection between the connector plugs and the connector receptacles. For example, the connector boot 442 can impede (e.g., prevent, stop, hinder, inhibit) fluids from reaching the interface between the connector plugs and the connector receptacles. The connector boots 442 can seal the interface between the connector plugs and the connector receptacles from fluid ingress. The connector boots 442 can reduce movement between the connector plugs and the connector receptacles, which can help maintain signal integrity during vibration and/or shock. The connector boots 442 can, at least in part, support (e.g., hold) the connector plug to reduce movement between the connector plug and the connector receptacles.

The connector boot 442 can include side walls 445 (e.g., longitudinal side walls). The side walls 445 can flare outward (e.g., curve outward, angle outward) to accommodate the geometry of the connector plugs. The side walls 445 can include a flange 446 (e.g., projection, extension). The flange 446 can include a rounded shape. The flange 446 can protrude to cover portions of the connector plug 362. The connector boot 442 can include end walls 444. The end walls 444 can flare outward (e.g., curve outward, angle outward) to accommodate the geometry of the connector plugs. As shown in FIG. 17B, the connector boot 442 can contact and/or support the geometry of the connector plugs, which can reduce fluid ingress and/or relative movement between the in-line disconnect box 440 and the connector plugs 362 to maintain signal integrity during vibration and/or shock.

In use, the connector boots 442 can be adhered to the inlets of the in-line disconnect box 440. For example, double-sided adhesive tape can be applied at the inner periphery of the inlet to the in-line disconnect box 440 and/or the outer periphery of the connector boot 442 to adhere the connector boots 442 to the in-line disconnect box 440. In some variants, the connector boot 442 can be coupled to the in-line disconnect box 440 by way of a variety of techniques, which can include fastening with screws, staples, clips, and/or other techniques.

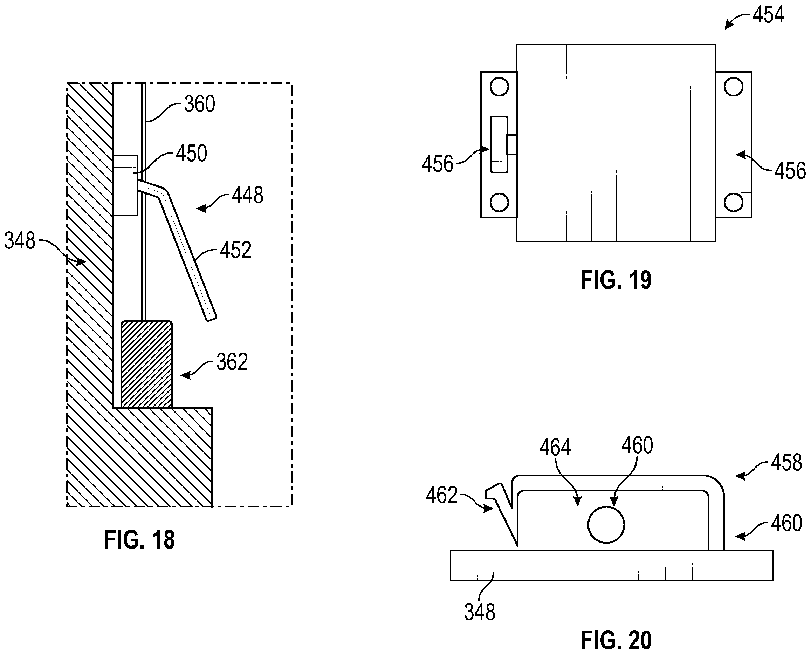

### I. Covers - FIGS. 18-20

FIG. 18 illustrates a covering 448 (e.g., overhang). The covering 448 can be disposed above the interface between a connector plug 362 and a connector receptacle (e.g., an upward facing connector receptacle). The covering 448 can help impede the ingress of fluids into the connector receptacle and/or interface between the connector plug 362 and the connector receptacle.

The covering 448 can include a base 450 that can be coupled to the display housing 348 and/or surrounding structure. The covering 448 can include an overhang 452 that can extend from the base 450. The overhang 452 can be angled downward over the connector receptacle and/or connector plug 362. In some variants, the covering 448 can include a feature (e.g., clamp, clip, etc.) to secure the cable 360.

FIG. 19 illustrates a cover 454. The cover 454 can be disposed over the connector plug 362, which can be proximate the connector receptacle (e.g., upward facing or downward facing). The cover 454 can help impede the ingress of fluids into the connector receptacle and/or interface between the connector plug 362 and the connector receptacle. The cover 454 can be coupled to the display housing 348 and/or surrounding structure. The cover 454 can include flanges 456, which can be disposed on opposing sides of the cover 454. In some variants, one flanges 456 is coupled to the display housing 348 and/or surrounding structure while the other flanges 456 is not. In some variants, the cover 454 can be biased to cover the connector plug 362 but can be deflected by pulling on the flange 456 not coupled to the display housing 348 and/or surrounding structure to access behind the cover 454.

FIG. 20 illustrates a cover 458. The cover 458 can be disposed over the connector plug 362, which can be proximate the connector receptacle (e.g., upward facing or downward facing). The cover 458 can help impede the ingress of fluids into the connector receptacle and/or interface between the connector plug 362 and the connector receptacle. The cover 458 can be coupled to the display housing 348 and/or surrounding structure. The cover 458 can include a fixed end 460 that can be coupled to the display housing 348 and/or surrounding structure. The cover 458 can include a free end 462. In some variants, the free end 462 can be pulled to deflect the cover 458 to access a space 464 behind the cover 458.

### J. Certain Terminology

Conditional language, such as "can," "could," "might," or "may," unless specifically stated otherwise, or otherwise understood within the context as used, is generally intended to convey that certain embodiments include or do not include, certain features, elements, and/or steps. Thus, such conditional language is not generally intended to imply that features, elements, and/or steps are in any way required for one or more embodiments.

Conjunctive language, such as the phrase "at least one of X, Y, and Z," unless specifically stated otherwise, is otherwise understood with the context as used in general to convey that an item, term, etc. may be either X, Y, or Z. Thus, such conjunctive language is not generally intended to imply that certain embodiments require the presence of at least one of X, at least one of Y, and at least one of Z.

Terms of orientation used herein, such as "top," "bottom," "longitudinal," "lateral," and "end" are used in the context of the illustrated embodiment. However, the present disclosure should not be limited to the illustrated orientation. Indeed, other orientations are possible and are within the scope of this disclosure. The term "vertical" refers to a direction that is parallel to the direction of the Earth's gravity and the term "horizontal" refers to a direction that is perpendicular to the direction of the Earth's gravity. Terms relating to circular shapes as used herein, such as diameter or radius, should be understood not to require perfect circular structures, but rather should be applied to any suitable structure with a cross-sectional region that can be measured from side-to-side. Terms relating to shapes generally, such as "circular" or "cylindrical" or "semi-circular" or "semi-cylindrical" or any related or similar terms, are not required to conform strictly to the mathematical definitions of circles or cylinders or other structures, but can encompass structures that are reasonably close approximations.

The terms "approximately," "about," and "substantially" as used herein represent an amount close to the stated amount that still performs a desired function or achieves a desired result. For example, in some embodiments, as the context may permit, the terms "approximately", "about", and "substantially" may refer to an amount that is within less than or equal to 10% of the stated amount. The term "generally" as used herein represents a value, amount, or characteristic that predominantly includes or tends toward a particular value, amount, or characteristic. As an example, in certain embodiments, as the context may permit, the term "generally parallel" can refer to something that departs from exactly parallel by less than or equal to 20 degrees and the term "generally perpendicular" can refer to something that departs from exactly perpendicular by less than or equal to 20 degrees.

### K. Summary

Although the connector systems, methods, and apparatuses have been disclosed in the context of certain embodiments and examples, the scope of this disclosure extends beyond the specifically disclosed embodiments to other alternative embodiments and/or uses of the embodiments and certain modifications and equivalents thereof. Various features and aspects of the disclosed embodiments can be combined with or substituted for one another in order to form varying modes. The scope of this disclosure should not be limited by the particular disclosed embodiments described herein.

Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a claimed combination can, in some cases, be excised from the combination, and the combination may be claimed as any subcombination or variation of any subcombination.

Moreover, while operations may be depicted in the drawings or described in the specification in a particular order, such operations need not be performed in the particular order shown or in sequential order, and all operations need not be performed, to achieve the desirable results. Other operations that are not depicted or described can be incorporated in the example methods and processes. For example, one or more additional operations can be performed before, after, simultaneously, or between any of the described operations. Further, the operations may be rearranged or reordered in other implementations. Also, the separation of various system components in the implementations described above should not be understood as requiring such separation in all implementations. The described components and systems can generally be integrated together in a single product or packaged into multiple products. Additionally, other implementations are within the scope of this disclosure.

Some embodiments have been described in connection with the accompanying drawings. The figures are drawn to scale where appropriate, but such scale should not be interpreted as limiting, since dimensions and proportions other than what are shown are contemplated and are within the scope of the disclosed invention. Distances, angles, etc. are merely illustrative and do not necessarily bear an exact relationship to actual dimensions and layout of the devices illustrated. Components can be added, removed, and/or rearranged. Further, the disclosure herein of any particular feature, aspect, method, property, characteristic, quality, attribute, element, or the like in connection with various embodiments can be used in all other embodiments set forth herein. Additionally, any methods described herein may be practiced using any device suitable for performing the recited steps.

In summary, various embodiments and examples of connector systems, methods, and apparatuses have been disclosed. This disclosure expressly contemplates that various features and aspects of the disclosed embodiments can be combined with, or substituted for, one another. Accordingly, the scope of this disclosure should not be limited by the particular disclosed embodiments and examples described above, but should be determined only by a fair reading of the claims that follow.

Also described herein are the following numbered clauses:
1. A connector boot configured to be disposed on a cover plate of an electronics box of an inflight entertainment system to improve resistance to fluids, vibration, or shock, the connector boot comprising:
   a plurality of openings configured to align with openings of the cover plate providing access to connector receptacles of the electronics box; and
   a first projection and a second projection, the first and second projections disposed on opposing sides of the connector boot;
   wherein the plurality of openings are configured to receive connector plugs therethrough to interface with connector receptacles of the electronics box; and
   wherein the connector boot is configured to be compressed between the connector plugs and the cover plate to improve resistance to fluids, vibration, or shock.
2. The connector boot of clause 1 or clause 2, wherein the first and second projections each comprise a rounded profile.
3. The connector boot of any preceding clause, wherein the connector boot comprises:
   a base wall comprising the plurality of openings;
   a pair of longitudinal side walls flaring outward and disposed on opposing longitudinal sides of the base wall;
   a pair of end walls disposed on opposing ends of the base wall and spanning between the pair of longitudinal side walls; and
   a plurality of partitions, wherein each partition of the plurality of partitions is disposed between adjacent openings of the plurality of openings of the base wall;
   wherein the pair of longitudinal sides walls are configured to contact the connector plugs to impede relative movement between the connector plugs and the connector receptacles.
4. The connector boot of any preceding clause, further comprising snap-fit features configured to enable the connector boot to be snap fit to the cover plate, the snap-fit features comprising protrusions protruding from a rear of the first and second projections.
5. The connector boot of any preceding clause, further comprising an adhesive component disposed on the rear of the connector boot, the adhesive component configured to adhere the connector boot to the cover plate.
6. The connector boot of any preceding clause, further comprising adhesive disposed on a rear of the connector boot, the adhesive configured to adhere the connector boot to the cover plate.
7. The connector boot of any preceding clause, wherein the connector boot is over-molded onto the cover plate.
8. The connector boot of clause 3, wherein the longitudinal side walls comprise an angled portion protruding from the base wall at an angle.
9. The connector boot of clause 3, wherein the plurality of partitions span between the pair of longitudinal side walls.
10. The connector boot of clause 3, wherein the plurality of partitions comprises pairs of opposing partitions protruding from the pair of longitudinal side walls to free ends between the pair of longitudinal side walls.
11. An enclosure configured to be coupled to a display housing of an inflight entertainment system and enclose a connector plug to improve resistance to fluids, vibration, or shock, the enclosure comprising:
   a base configured to be coupled to the display housing;
   a cover with a peripheral wall, the peripheral wall having an opening through which the connector plug can interface with a connector receptacle of the display housing;
   a hinge rotatably coupling the cover to the base such that the cover can be rotated open to access an interior of the enclosure and rotated closed to enclose the connector plug within the interior; and
   an integrated cable clip configured to clamp a cable of the connector plug with the cover rotated closed to impede relative movement between the connector plug and the connector receptacle to maintain signal integrity when exposed to vibration or shock.
12. The enclosure of clause **11,** wherein the integrated cable clip comprises a channel in the peripheral wall of the cover and a groove in a flange of the base that clamp the cable of the connector plug.
13. The enclosure of clause 12, wherein the channel is configured to contact one side of the cable and the groove is configured to contact the other side of the cable.
14. The enclosure of clause 12 or clause 13, wherein the channel and groove cooperate to form an aperture through which the cable extends with the cover rotated closed.
15. The enclosure of any of clauses 11 to 14, wherein the enclosure comprises a locking mechanism configured to releasably couple the cover to the base to enclose the interior.
16. The enclosure of clause 15, wherein the locking mechanism comprises a deflectable member and a catch, and wherein one of the base and cover comprises the deflectable member and the other of the base and cover comprises the catch.
17. The enclosure of clause 16, wherein the deflectable member is configured to engage an edge of the catch to releasably couple the cover to the base in the closed configuration.
18. The enclosure of any of clauses 11 to 17, wherein the hinge is a living hinge.
19. A kit comprising the enclosure of any of clauses 11 to 18 and a sealing component, the sealing component comprising an adhesive configured to adhere the sealing component to the display housing around the connector receptacle, wherein the sealing component is configured to be compressed between the connector plug and the display housing to impede an ingress of fluid.
20. A cable clip configured to be coupled to a housing of an inflight entertainment system to secure a cable of a connector plug to improve resistance to vibration or shock, the cable clip comprising:
   a base plate configured to be coupled to the housing;
   a deflectable member comprising a living hinge and a locking end, the locking end comprising a bend and a recess, the bend configured to bias the locking end to a V-shaped configuration; and
   a catch comprising a cavity and an edge configured to engage the recess of the locking end of the deflectable member;
   wherein the deflectable member is configured to be bent at the living hinge to insert the locking end into the cavity such that the recess, biased by the bend, springs to engage the edge of the catch so that the cable of the connector plug is restrained between the base plate, deflectable member, and the catch.

## Claims

1. An enclosure configured to be coupled to a display housing of an inflight entertainment system and enclose a connector plug to improve resistance to fluids, vibration, or shock, the enclosure comprising:
a base configured to be coupled to the display housing;
a cover with a peripheral wall, the peripheral wall having an opening through which the connector plug can interface with a connector receptacle of the display housing;
a hinge rotatably coupling the cover to the base such that the cover can be rotated open to access an interior of the enclosure and rotated closed to enclose the connector plug within the interior; and
an integrated cable clip configured to clamp a cable of the connector plug with the cover rotated closed to impede relative movement between the connector plug and the connector receptacle to maintain signal integrity when exposed to vibration or shock.

2. The enclosure of Claim 1, wherein the integrated cable clip comprises a channel in the peripheral wall of the cover and a groove in a flange of the base that clamp the cable of the connector plug.

3. The enclosure of Claim 2, wherein the channel is configured to contact one side of the cable and the groove is configured to contact the other side of the cable.

4. The enclosure of Claim 2 or 3, wherein the channel and groove cooperate to form an aperture through which the cable extends with the cover rotated closed.

5. The enclosure of any preceding claim, wherein the enclosure comprises a locking mechanism configured to releasably couple the cover to the base to enclose the interior.

6. The enclosure of Claim 5, wherein the locking mechanism comprises a deflectable member and a catch, and wherein one of the base and cover comprises the deflectable member and the other of the base and cover comprises the catch.

7. The enclosure of Claim 6, wherein the deflectable member is configured to engage an edge of the catch to releasably couple the cover to the base in the closed configuration.

8. The enclosure of any preceding claim, wherein the hinge is a living hinge.

9. A kit comprising the enclosure of any preceding claim and a sealing component, the sealing component comprising an adhesive configured to adhere the sealing component to the display housing around the connector receptacle, wherein the sealing component is configured to be compressed between the connector plug and the display housing to impede an ingress of fluid.
